(19) **Europäisches Patentamt**
**European Patent Office**
**Office européen des brevets**

(11) **EP 4 741 864 A1**

(12) **EUROPEAN PATENT APPLICATION**

(43) Date of publication:
**13.05.2026 Bulletin 2026/20**

(21) Application number: **24212063.2**

(22) Date of filing: **11.11.2024**

(51) International Patent Classification (IPC):
**G01R 33/56** (2006.01)    **G01R 33/561** (2006.01)

(52) Cooperative Patent Classification (CPC):
**G01R 33/5608;** G01R 33/561; G01R 33/5611

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Siemens Healthineers AG**
**91301 Forchheim (DE)**

(72) Inventors:
- **Nickel, Marcel Dominik**
  **91074 Herzogenaurach (DE)**
- **Zeller, Mario**
  **91054 Erlangen (DE)**
- **Littmann, Arne**
  **91052 Erlangen (DE)**
- **Meixner, Christian**
  **91054 Erlangen (DE)**

(74) Representative: **Siemens Healthineers**
**Patent Attorneys**
**Postfach 22 16 34**
**80506 München (DE)**

(54) **IMAGE RECONSTRUCTION IN MAGNETIC RESONANCE IMAGING COMPRISING A DATA CONSISTENCY OPERATION AND A REGULARIZATION OPERATION**

(57)    For image reconstruction in MRI, MRI data (20) corresponding to an MRI acquisition according to a sampling scheme is received, wherein the sampling scheme defines a corresponding sampling number indicating how often the respective k-space point has been sampled in the MRI acquisition. Reconstructed image data (X) is generated by applying processing steps (24) comprising a data consistency operation (25) to initial image data ($X_0$). A projection matrix according to the sampling scheme is received and is modified by scaling its entries depending on the sampling numbers. The data consistency operation (25) is carried out depending on a forward operator (A) comprising the modified projection matrix.

FIG 2

**Description**

The present invention is directed to a computer-implemented method for image reconstruction in magnetic resonance imaging, MRI, wherein MRI data is received, the MRI data corresponding to an MRI acquisition according to a predefined sampling scheme, wherein the sampling scheme defines, for all k-space points, a corresponding sampling number indicating how often the respective k-space point has been sampled in the MRI acquisition, and wherein reconstructed image data is generated by applying processing steps to predefined initial image data, the processing steps comprising a data consistency operation and a regularization operation. The invention is further directed to a corresponding data processing system, to MRI arrangement comprising said data processing system, and to a corresponding computer program product.

Here and in the following, the term "image data" denotes image data in position space, also denoted as image space or image domain, unless stated otherwise. In MRI, image reconstruction denotes the process to generate a two-dimensional image or a three-dimensional image, typically in form of multiple two-dimensional images for multiple positions along the so-called slice direction, in position space from MRI data acquired in k-space depending on MR signals being emitted by an object to be imaged.

In general, the k-space and the position space are related to each other via Fourier transformation. When parallel MRI is pursued, datasets are received from multiple receiver coils, which receive the emitted MR signals. Furthermore, k-space subsampling techniques may be employed, where the k-space is sampled with a sampling rate that is too low to fulfil the Nyquist criterion. The latter is also denoted as undersampling or incomplete sampling. The multiple coils or the datasets provided by them, respectively, are denoted as coil channels. The reconstructed image data can therefore not be obtained solely by Fourier transforming the acquired k-space data. Rather, more sophisticated reconstruction techniques need to be used. Various methods for MR image reconstruction are known, which may for example involve iterative processes and/or optimizations based on physical relations.

Furthermore, trained machine learning models, MLMs, for example artificial neural networks, ANNs, in particular deep convolutional neural networks, CNNs, may be used for the MR image reconstruction, for example in combination with conventional reconstruction approaches. Therein, "conventional" refers to the fact that no MLM is involved. Such methods are sometimes called deep learning, DL, reconstructions. A review of the topic is presented in the publication G. Zeng et al.: "A review on deep learning MRI reconstruction without fully sampled k-space." BMC Med Imaging 21, 195 (2021).

U-Net, introduced in the publication of O. Ronneberger et al.: "U-Net: Convolutional Networks for Biomedical Image Segmentation" (arXiv:1505.04597v1), is a well-known CNN usable for example for image segmentation or image enhancement.

The publication by K. Hammernik et al.: "Σ-net: Systematic Evaluation of Iterative Deep Neural Networks for Fast Parallel MR Image Reconstruction" (arXiv:1912.09278v1) describes a deep-learning enabled unrolled neural network Σ-net and systematically investigates the influence of various data consistency layers, (semi-)supervised learning and ensembling strategies, defined in a Σ-net, for accelerated parallel MR image reconstruction using deep learning.

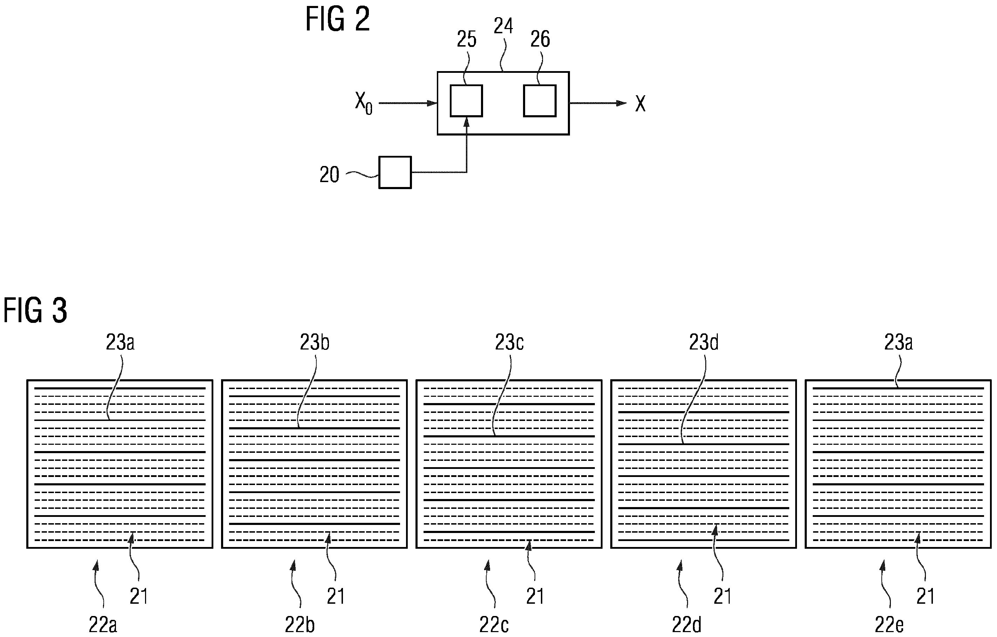

The Σ-net may be considered as a deep-learning enabled unrolled neural network. Another example for such unrolled neural network is implemented in the product solution Deep Resolve Boost, DRB, (https://www.siemens-healthi neers.com/magnetic-resonance-imaging/options-and-upgrades/clinical-applications/deep-resolve-boost, retrieved on October 25, 2024, 08:24am). The underlying concept is described in the publication J. Hermann et al.: "Feasibility and Implementation of a Deep Learning MR Reconstruction for TSE Sequences in Musculoskeletal Imaging", Diagnostics 2021, 11, 1484 (see for example Figure 2 and the corresponding description therein).

Such deep-learning enabled unrolled neural networks outperform conventional parallel imaging methods in the achievable acceleration of data acquisition. Such networks consist of cascades of gradient update and regularization steps. While the regularization is for example enabled by an MLM, such as U-net or a Down-Up network, the gradient update steps typically use the measured MRI data in k-space to ensure data consistency.

The publication by S.H. Joshi et al.: "MRI resolution enhancement using total variation regularization", Proc IEEE Int Symp Biomed Imaging, 2009:161-164, describes the total variation regularization technique for MRI applications. The publication by M. Guerquin-Kern et al.: "Wavelet-regularized reconstruction for rapid MRI" 2009 IEEE International Symposium on Biomedical Imaging: From Nano to Macro, Boston, MA, USA, pp. 193-196, describes the Wavelet-regularization technique for MRI applications.

In low-SNR (signal-to-noise ratio) applications there is often the situation that data are acquired with so-called intrinsic averaging or PAT (parallel acquisition techniques) averaging. For example in conventional GRAPPA imaging combined with PAT averaging, each acquisition shot is reconstructed separately and the obtained reconstructions are averaged. An advantage of this approach compared to the acquisition of one fully sampled average is that motion sensitivity is reduced due to the averaging over multiple acquisition shot and therefore multiple time-periods. A disadvantage is noise amplification.

PAT averaging techniques are for example described in the publication of S. Kannengiesser et al.: "Motion Compensation Using Parallel Imaging Without Extra Reference Measurements And With Modified Reordering", Proc. Intl.

Soc. Mag. Reson. Med. 11 (2004).

The use of DL reconstructions can reduce this disadvantage. Because of the associated computational demand, a repeated execution of the MLM for one scan is often not feasible, however. For such situations, the application of deep-learning enabled unrolled neural networks is not conducive because the solution is pushed towards being consistent with the original data in the data consistency step. Therefore, a denoising of the image by the MLM effectively does not take place as the original data is noisy. Currently, PAT averaging can therefore not be combined with deep-learning enabled unrolled neural networks. Instead, for example conventional averaging is performed such that the same k-space lines are acquired in each shot and averaged beforehand. The result is, however, prone to infolding artifacts.

It is an objective of the present invention to overcome said drawbacks at least in part.

This objective is achieved by the subject matter of the independent claim. Further implementations and preferred embodiments are subject matter of the dependent claims.

The invention is based on the idea to integrate a scaling in the forward operator, which is required to carry out the data consistency operation, the scaling taking into account how often a specific k-space point has been sampled during the MRI data acquisition.

According to an aspect of the invention, a computer-implemented method for image reconstruction in MRI is provided. Therein, MRI data is received, the MRI data corresponding to an MRI acquisition according to a predefined sampling scheme, wherein the sampling scheme defines, for all k-space points, a corresponding sampling number indicating how often the respective k-space point has been sampled in the MRI acquisition. Reconstructed image data is generated by applying processing steps to predefined initial image data, the processing steps comprising a data consistency operation and a regularization operation. A projection matrix according to the sampling scheme is received and the projection matrix is modified by scaling entries, in particular all entries, of the projection matrix depending on the respective sampling numbers defined by the sampling scheme. The data consistency operation is carried out depending on a forward operator, in particular a linear forward operator, which comprises the modified projection matrix.

Unless stated otherwise, all steps of the computer-implemented method may be performed by a data processing system, which comprises at least one data processing device. In particular, the at least one data processing device is configured or adapted to perform the steps of the computer-implemented method. For this purpose, the at least one data processing device may for example store a computer program comprising instructions which, when executed by the at least one data processing device, cause the at least one data processing device to execute the computer-implemented method. The expressions "data processing system" and "at least one data processing device" may be used interchangeably, here and in the following. This holds also for respective expressions derived therefrom.

In case the at least one data processing device comprises two or more data processing devices, certain steps carried out by the at least one data processing device may also be understood such that different data processing devices carry out different steps or different parts of a step. In particular, it is not required that each data processing device carries out the steps completely. In other words, carrying out the steps may be distributed amongst the two or more data processing devices.

From each implementation of the computer-implemented method, a respective implementation of a method for image reconstruction in MRI, which is not purely computer-implemented, is obtained by including respective steps of generating the MRI data, in particular by an MRI device.

Receiving data or information, in particular the MRI data or the projection matrix, may, for example, involve receiving the data, in particular by the data processing system from a sending entity, or reading the data from a data storage or receiving a data stream containing the data, or extracting the data from the data stream, and so on. In particular, wired or wireless data transmission can be used for this purpose. In particular, the data transmission may take place between a hardware and/or software interface of the sending entity and a hardware and/or software interface of the data processing system.

The MRI data are, in particular, measured data or data acquired by an MRI device and represent an imaged object. The MRI data are for example given in k-space.

The MRI data are acquired, for example before the computer-implemented method according to the invention is carried out, by the MRI acquisition. The MRI acquisition may correspond to a full sampling of the k-space or to incomplete sampling, also denoted as undersampling. In other words, the MRI data may be fully sampled data or undersampled data. An undersampled acquisition is an acquisition, whose k-space sampling scheme does not fulfil the Nyquist criterion. In some embodiments, the MRI acquisition may comprise two or more acquisition shots. In this case, each of the two or more acquisition shots may correspond to an undersampling. Nevertheless, also in this case the whole MRI acquisition may correspond to full sampling or incomplete sampling. It is also possible that one or more of the two or more acquisition shots are undersampled shots and one or more of the two or more acquisition shots are fully sampled shots. Furthermore, the two or more acquisition shots may comprise acquisition shots which sample the same k-space points, in particular at different times.

The processing steps may comprise a plurality of iterations, also denoted as cascades for example in J. Hermann et al., or even two or more sets of cascades. For example, as described with respect to Figure 2 of J. Hermann et al., the sets cascades may be denoted as pre-cascades, cascades, denoted as main cascades in the following, and post cascades, wherein in particular the pre-cascades and post-cascades are optional. Each of the pre-cascades, the main cascades and the post cascades may be carried out iteratively including the special case of a single iteration. In particular, one or more iterations of the optional pre-cascades may be followed by one or more of the main cascades, which may be followed by one or more iterations of the optional post-cascades.

At least the main cascades comprise the data consistency operation, denoted as gradient update in Figure 2 of J. Hermann et al., and the regularization operation. For example, each iteration of the main cascades comprises the data consistency operation and the regularization operation. Furthermore, also the pre-cascades and/or the post-cascades may comprise the data consistency operation.

Analogously, the processing steps used in the computer-implemented method according to the invention may comprise the data consistency operation and/or the regularization multiple times, in some embodiments. In particular, the explanations here and in the following regarding the data consistency operation and the regularization operation may hold for all the data consistency operations and/or all the regularization operations comprised by the processing steps.

It is highlighted, however, that the processing steps used in the computer-implemented method according to the invention is not necessarily identical to the implementation of J. Hermann et al.

The initial image data may for example be a guess for the reconstructed MR image data or it may also be one or more images with constant pixel values everywhere, for example zero.

The regularization operation may comprise the application of a trained machine learning model, MLM, for example an artificial neural network, ANN, for image enhancement or an application of a conventional regularization step, for example a wavelet regularization or a total variation regularization.

The forward operator may also be denoted as signal model matrix or as encoding matrix. For example, the forward operator may depend on respective predefined coil sensitivity maps for each of at least two coil channels in case parallel imaging is pursued. The coil sensitivity maps may in general be determined by methods known in the art and may therefore be predefined. Furthermore, the forward operator may contain a Fourier transform and a coil sensitivity map matrix, which contains the predefined coil sensitivity maps for all coil channels. Furthermore, the forward operator comprises the modified projection matrix. In conventional approaches, for example in J. Hermann et al., the forward operator comprises the projection matrix but not the modified projection matrix.

The sampling scheme may for example be defined by a discrete function p(k), wherein k denotes coordinates, for example three-dimensional or two-dimensional coordinates, in k-space and p(k) is non-zero, for example equal to one, only at coordinates in k-space, which shall be sampled or, in other words, measured, and equal to zero otherwise. The projection matrix represents p(k) in this case. It is noted that p(k) may be different for different acquisition shots but also in this case an overall projection matrix may be provided based on the p(k) for all acquisition shots.

Scaling an entry of the projection matrix may for example correspond to the multiplication of the respective entry with a scaling factor, which depends on the respective sampling number for the respective k-space point. The scaling factor may be the same for all entries of the projection matrix, in particular if the sampling number is the same for all k-space points, but may also differ between different entries otherwise.

The data consistency operation may for example correspond to the application of

$$A^H(A\,z - y),$$

with the current image data z, wherein $A$ is the forward operator, $A^H$ is the Hermitian adjoint of the forward operator and y is depends on the MRI data. In case parallel imaging is used, y, which may be a vector or matrix, is for example determined by scaling the MRI data or averaged MRI data with 1/R, wherein R denotes the corresponding acceleration factor.

The current image data z may be given by the initial image data or by intermediate image data resulting from processing the initial image data. In particular, it depends on the position of the data consistency operation in the sequence of the processing steps. In general, the initial image data may be processed by applying a first portion of the processing steps to the initial image data resulting in partially processed image data. The data consistency operation is then applied to the partially processed image data and the result of the data consistency operation is further processed by applying a second portion of the processing steps to the result of the data consistency operation to eventually generate the reconstructed image data.

By using the modified projection matrix in the forward operator instead of the original projection matrix, the effect or strength of the data consistency operation is adjusted according to the sampling numbers. Consequently, the current image data z, is driven towards the original MRI data to the extent justified by the respective sampling number. Therefore, the effect of the regularization operation and the effect of the data consistency operation are adjusted to each other. The effectivity of the regularization operation, for example the image enhancement by the MLM, is therefore increased.

According to several embodiments, the sampling number is at least two for each k-point of a set of k-space points, wherein the set of k-space points is, in particular, defined by the sampling scheme. The data consistency operation comprises an averaging operation based on the MRI data for the set of k-space points.

In other words, overall the k-space points of the set of k-space points are sampled at least twice during the whole MRI acquisition. The set of k-space points may, in principle consist of a single k-space point or several isolated k-space points. In many use cases, however, the set of k-space points comprises all k-space points according to the Nyquist criterion or several k-space lines or columns or, in case of non-cartesian sampling, one or more sequences of k-space points lying on other geometric curves, for example radial rays et cetera.

The averaged MRI data results, in particular, from the MRI data by replacing the respective values for a given k-space point of the set of k-space points by the average value over all values determined for that k-space point. Thus, the averaged MRI data comprises exactly one value for all k-space points. Since the forward operator is linear, the averaging may, however, also be performed in image domain instead.

According to several embodiments, the regularization operation comprises an application of a trained MLM for image enhancement, for example to the result of the data consistency operation.

In general terms, a trained MLM may mimic cognitive functions that humans associate with other human minds. In particular, by training based on training data the MLM may be able to adapt to new circumstances and to detect and extrapolate patterns. Another term for a trained MLM is "trained function".

In general, parameters of an MLM can be adapted or updated by means of training. In particular, supervised training, semi-supervised training, unsupervised training, reinforcement learning and/or active learning can be used. Furthermore, representation learning, also denoted as feature learning, can be used. In particular, the parameters of the MLMs can be adapted iteratively by several steps of training. In particular, within the training a certain loss function, also denoted as cost function, can be minimized. In particular, within the training of an artificial neural network, ANN, the backpropagation algorithm can be used.

In particular, an MLM can comprise an ANN, a support vector machine, a decision tree and/or a Bayesian network, and/or the MLM can be based on k-means clustering, Q-learning, genetic algorithms and/or association rules. In particular, an ANN can be or comprise a deep neural network, a convolutional neural network or a convolutional deep neural network. Furthermore, an ANN can be an adversarial network, a deep adversarial network and/or a generative adversarial network, GAN.

In said embodiments, the MLM is an MLM for image enhancement. In other words, an input to the MLM is an image and an output of the MLM is an image as well. Therein, the output image is enhanced with respect to the input image. What exactly is the effect of the enhancement depends on the training data and the corresponding ground truth data used for training the MLM. For example, the training data may be intentionally corrupted or deteriorated using for example by applying blurring filters, adding noise, reducing the image resolution and/or adding artifacts and so forth. By means of the training, the MLM learns to enhance an input image accordingly.

In other words, the image enhancement may comprise a noise reduction and/or an image sharpening, an image resolution enhancement and/or an artifact reduction.

For example, in case the MLM is an ANN, it may be a U-Net, as described in the publication of O. Ronneberger et al mentioned in the introductory part of the present disclosure, or an ANN based on the U-Net architecture. Furthermore, ANN architectures as used in J. Hermann et al. or in K. Hammernik et al. may be used for the MLM.

It is noted that the training of the MLM is, in general, not part of the computer-implemented method for image reconstruction according to the invention even though embodiments of the computer-implemented method comprising the training of the MLM are possible.

According to several embodiments, the MRI acquisition comprises two or more acquisition shots, each acquisition shot of the two or more acquisition shots corresponding to an incomplete sampling of the k-space.

Consequently, the acquisition time is reduced. Also in this case, the whole MRI acquisition may correspond to full sampling or incomplete sampling.

In particular, all k-space points of the set of k-space points or a part of them may be sampled during at least two different acquisition shots of the two or more acquisition shots. Therefore, motion sensitivity is reduced since effectively the averaging operation takes into account data from different time-points.

According to several embodiments, a subsampling scheme of a first acquisition shot of the two or more acquisition shots is identical or partially identical to a subsampling scheme of a second acquisition shot of the two or more acquisition shots.

Consequently, all k-space points sampled by the first acquisition shot are also sampled by the second acquisition shot and vice versa or a part of the k-space points sampled by the first acquisition shot is also sampled by the second acquisition shot. Therefore, motion sensitivity is reduced.

According to several embodiments, the scaling of a respective entry of the projection matrix comprises multiplying the respective entry with a factor $\alpha$, which is directly proportional to the corresponding sampling number.

Since each entry of the projection matrix is associated uniquely to a corresponding k-space point, the corresponding sampling number for a given entry of the projection matrix is given by the sampling number of said associated k-space point.

Consequently, the more often the respective k-space point is sampled during the MRI acquisition, the higher is the factor $\alpha$ and therefore the respective entry of the modified projection matrix. In the data consistency operation, the respective entry is therefore given more weight in the current image data z compared to the measured MRI data y.

According to several embodiments, the factor $\alpha$ is indirectly proportional to an acceleration factor of the respective acquisition shot.

In particular, the factor $\alpha$ may be given by the corresponding sampling number divided by the acceleration factor.

According to several embodiments, averaged MRI data is computed by averaging respective values of the MRI data corresponding to the same k-space point of the set of k-space points and the data consistency operation is carried out depending on the averaged MRI data.

In particular, the MRI data comprises two or more respective values for each k-space point of the set of k-space points. The averaging operation comprises averaging said two or more respective values for each k-space point of the set of k-space points.

In other words, the averaging is carried out in k-space in this case. This allows for a computationally particularly efficient implementation. In general, however, the averaging may also be carried out in image domain due to the linearity of the forward operator.

According to several embodiments, intermediate image data is determined depending on the initial image data. The data consistency operation comprises computing intermediate k-space data depending on the intermediate image data and the forward operator and computing a difference between the intermediate k-space data and the averaged MRI data.

In particular, the intermediate k-space data may be given by ($A\,z$) with the forward operator $A$ and the intermediate image data z and the data consistency operation comprises computing the term ($A\,z - y$). Thus, the data consistency operation penalizes a strong deviation of the content of the intermediate image data from the content of the averaged MRI data. By scaling the entries of the projection matrix, this is balanced in accordance with the multiple sampling of the set of k-space points.

Computing the intermediate image data may, in particular, involve one or more iterations of the processing steps as described above. In some situations, the intermediate image data may also be given by the initial image data.

For example, the data consistency operation comprises converting the difference between the intermediate k-space data and the averaged MRI data into the image domain based on the forward operator, in particular based on the adjoint forward operator, and computing a sum of the converted difference and the intermediate image data. The reconstructed image data is generated depending on the sum of the converted difference and the intermediate image data.

In particular, the data consistency operation comprises computing the term $A^H(A\,z - y)$. Consequently, the following processing steps may again be carried out in the image domain.

According to several embodiments, regularized image data is generated by the regularization operation depending on the sum of the converted difference and the intermediate image data. The reconstructed image data is generated depending on the regularized image data.

For example, the trained MLM may be applied to the sum of the converted difference and the intermediate image data.

According to a further aspect of the invention, a data processing system that is configured to carry out a computer-implemented method according to the invention is provided.

In the present disclosure, the terms "data processing system" and "at least one data processing device" can be used interchangeably. In particular, a data processing device can be understood to mean a data processing device that contains a processing circuit. The data processing device can therefore, in particular, process data for the purpose of performing computing operations. This may also include operations for performing indexed access to a data structure, for example a look-up table, LUT, as well as a data processing method implemented in hardware.

The data processing device may include, in particular, one or more computers, one or more microcontrollers and/or one or more integrated circuits, for example one or more application-specific integrated circuits, ASIC, one or more field-programmable gate arrays, FPGA, and/or one or more systems-on-a-chip, SoC. The data processing device may also include one or more processors, for example one or more microprocessors, one or more central processing units, CPUs, one or more graphics processing units, GPUs, and/or one or more signal processors, in particular one or more digital signal processors, DSPs. The data processing device may also include a physical or virtual network of computers or other of the mentioned units.

In various embodiments, the data processing device includes one or more hardware and/or software interfaces and/or one or more storage units.

A storage unit may be a volatile data memory, for example a dynamic random access memory, DRAM, or a static random access memory, SRAM, or a non-volatile data memory, for example a read-only memory, ROM, a programmable read-only memory, PROM, an erasable programmable read-only memory, EPROM, an electrically erasable programmable read-only memory, EEPROM, a flash memory or flash EEPROM, a ferroelectric random access memory, FRAM, a magnetoresistive random access memory, MRAM, or a phase-change random access memory, PCRAM.

According to a further aspect of the invention, an MRI arrangement is provided. The MRI arrangement comprises a data processing system according to the invention and an MRI device, which is configured to generate the MRI data by carrying out the MRI acquisition.

Further implementations of the MRI arrangement according to the invention follow directly from the various embodiments of the computer-implemented method according to the invention and vice versa. In particular, individual features and corresponding explanations as well as advantages relating to the various implementations of the computer-implemented method according to the invention can be transferred analogously to corresponding implementations of the MRI arrangement according to the invention.

According to a further aspect of the invention, a computer program comprising instructions is provided. When the instructions are executed by a data processing system, the instructions cause the data processing system to carry out a computer-implemented method according to the invention.

The instructions may be provided as program code, for example. The program code can for example be provided as binary code or assembler and/or as source code of a programming language, for example C, and/or as program script, for example Python.

According to a further aspect of the invention, a computer-readable storage medium, in particular a tangible and/or non-transient computer readable storage medium, storing a computer program according to the invention is provided.

The computer program and the computer-readable storage medium are respective computer program products comprising the instructions.

Further features and feature combinations of the invention are obtained from the figures and their description as well as the claims. In particular, further implementations of the invention may not necessarily contain all features of one of the claims. Further implementations of the invention may comprise features or combinations of features, which are not recited in the claims.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,

FIG 1 shows schematically an exemplary embodiment of an MRI arrangement according to the invention;

FIG 2 shows a schematic block diagram of an exemplary embodiment of a computer-implemented method for image reconstruction according to the invention;

FIG 3 shows schematically sampling schemes for MRI acquisition shots according to MRI data for use in a further exemplary embodiment of a computer-implemented method for image reconstruction according to the invention;

FIG 4 shows a schematic block diagram of a further exemplary embodiment of a computer-implemented method for image reconstruction according to the invention;

FIG 5 shows a schematic block diagram of a further exemplary embodiment of a computer-implemented method for image reconstruction according to the invention;

FIG 6 shows a schematic block diagram of processing steps of a further exemplary embodiment of a computer-implemented method for image reconstruction according to the invention;

FIG 7 shows a schematic block diagram of processing steps of a further exemplary embodiment of a computer-implemented method for image reconstruction according to the invention;

FIG 8 shows a schematic block diagram of processing steps of a further exemplary embodiment of a computer-implemented method for image reconstruction according to the invention;

FIG 9 shows schematically an example of a convolutional neural network; and

FIG 10 shows schematically a further example of a convolutional neural network.

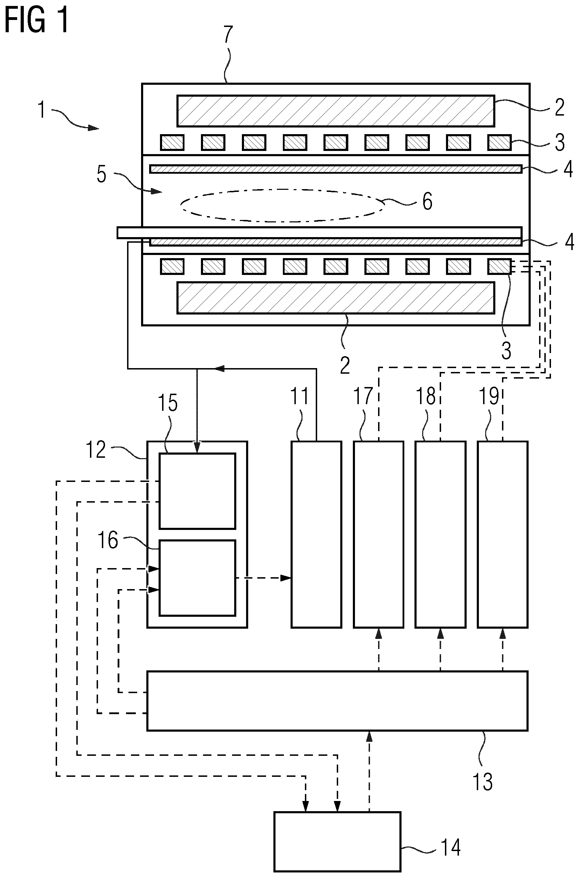

FIG 1 shows schematically an exemplary embodiment of an MRI arrangement 1 according to the invention. The MRI arrangement 1 comprises a data processing system 14 according to the invention, which is configured to carry out a computer-implemented method for image reconstruction in MRI according to the invention based on MRI data 20, and an MRI device 7, which is configured to generate the MRI data 20 by carrying out an MRI acquisition.

For example, the MRI device 7 comprises a housing defining a bore 5 and a main magnet arrangement 2, which is configured to generate a main magnetic field, also denoted as polarizing magnetic field, within the bore 5. The MRI device 7 comprises an RF system 4, 11, 12, which is configured to apply RF pulses to the object 6, in particular a body part of a patient, disposed within the bore 5, and to receive MR signals emitted from the target material. For example, the main magnet arrangement 2 may generate a uniform main magnetic field B0 as the main magnetic field and at least one RF coil 4 of the RF system 4, 11, 12 may emit an excitation field B1.

According to MR techniques, the object 6 is subjected to the main magnetic field, causing the nuclear spins in the target material to process about the direction of the main magnetic field at their characteristic Larmor frequency. A net magnetic moment Mz is produced in the direction z of the main magnetic field, and the randomly oriented magnetic moments of the nuclear spins cancel out one another in the x-y-plane.

When the object 6 is then subjected to the transmit RF magnetic field, which is for example in the x-y plane and near the Larmor frequency, the net magnetic moment rotates out of the z-direction generating a net in-plane magnetic moment, whose projection rotates in the x-y plane with the Larmor frequency. In response, MR signals are emitted by the excited spins when they return to their state before the excitation. To generate the MRI data 20, the emitted MR signals are detected, for example by the at least one RF coil 4 and/or one or more dedicated detection coils, digitized in a receiver channel 15 of an RF controller 12 of the RF system 4, 11, 12.

In particular, gradient coils 3 of the MRI device 7 may produce magnetic field gradients Gx, Gy, and Gz for position-encoding of the MR signals. Accordingly, MR signals are emitted only by such nuclei of the target material, which correspond to the particular Larmor frequency. For example, Gz is used together with a bandwidth-limited RF pulse to select a slice perpendicular to the z-direction and consequently may also be denoted as slice selection gradient. In alternative examples, Gx, Gy, and Gz may be used in any predefined combination with a bandwidth-limited RF pulse to select a slice perpendicular to the vector sum of said gradient combination. The gradient coils 3 may be supplied with current by respective amplifiers 17, 18, 19 for generating the respective gradient fields in x-direction, y-direction, and z-direction, respectively. Each amplifier 17, 18, 19 may include a respective digital-to-analog converter, which is controlled by a sequence controller 13 to generate respective gradient pulses at predefined time instances.

The sequence controller 13 may control the generation of RF pulses by an emitter channel 16 of the RF controller 12 and an RF power amplifier 11 of the RF system 4, 11, 12.

It is noted that the components of the MRI device 7 can also be arranged differently from the arrangement shown in FIG 1. For example, the gradient coils 3 may be arranged inside the bore 5, similar as shown for the at least one RF coil 4. It is further noted that each component of the MRI device 7 may include other elements, which are required for the operation thereof, and/or additional elements for providing functions other than those described in the present disclosure.

FIG 2 shows a schematic block diagram of an exemplary embodiment of a computer-implemented method for image reconstruction according to the invention.

Therein, the MRI data 20 is received. The MRI data 20 corresponds to an MRI acquisition carried out by the MRI device 7 according to a predefined sampling scheme, wherein the sampling scheme defines, for all k-space points 21 (see FIG 3), a corresponding sampling number indicating how often the respective k-space point has been sampled in the MRI acquisition.

Reconstructed image data X is generated by applying processing steps 24 to predefined initial image data $X_0$. The processing steps 24 comprise a data consistency operation 25 and a regularization operation 26.

In some embodiments, the sampling number is at least two for a set of k-space points 23a (see FIG 3) and the data consistency operation 25 comprises an averaging operation based on the MRI data 20 for the set of k-space points 23a.

A projection matrix according to the sampling scheme is received and the projection matrix is modified by scaling entries of the projection matrix depending on the respective sampling numbers defined by the sampling scheme. The data consistency operation 25 is carried out depending on a forward operator A comprising the modified projection matrix.

For example, the MRI acquisition may comprise two or more acquisition shots 22a, 22b, 22c, 22d, 22e, each of the two or more acquisition shots 22a, 22b, 22c, 22d, 22e corresponding to an incomplete sampling of the k-space, as depicted schematically in FIG 3. In the example of FIG 3, five acquisition shots 22a, 22b, 22c, 22d, 22e are shown, each with an acceleration factor of R = 4, as only every fourth k-space line is sampled by a given acquisition shots 22a, 22b, 22c, 22d, 22e.

For example, the first acquisition shot 22a samples a subset 23a of all k-space points 21, the second acquisition shot 22a samples a subset 23b of all k-space points 21, the third acquisition shot 22c samples a subset 23c of all k-space points 21, and the fourth acquisition shot 22d samples a subset 23d of all k-space points 21. Consequently, the first four acquisition shots 22a, 22b, 22c, 22d in combination sample the k-space completely, for example. The fifth acquisition shot 22e samples the same subset 23a as the first acquisition shot 22a.

In this exemplary scenario, the sampling number is equal to two for each k-space point of the subset 23a and equal to one for all other k-space points.

The scaling of a respective entry of the projection matrix comprises for example multiplying the respective entry with a factor $\alpha$, which is directly proportional to the corresponding sampling number and, for example, indirect proportional to the acceleration factor. For the example of FIG 3, $\alpha$ may for example be 2/4 = 0.5 for all k-space points of the subset 23a and 1/4 =0.25 for the k-space points of the subsets 23b, 23c, 23d.

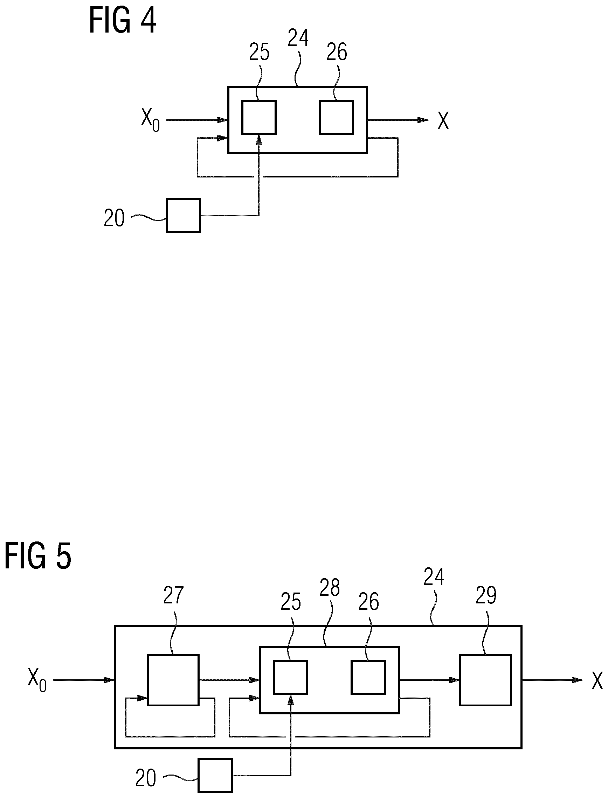

As indicated in FIG 4, the processing steps 24 may comprise a plurality of iterations, each of them comprising the data consistency operation 25 and a regularization operation 26. Said iterations may for example correspond to the main cascades described in J. Hermann et al. In an initial iteration, the initial image data $X_0$ is processed by the processing steps 24 and output image data is generated. The output image data is then the new input for the subsequent iteration and the processing steps 24 are applied to the output image resulting in further output image data et cetera until all iterations are carried out and finally the reconstructed image data X is output.

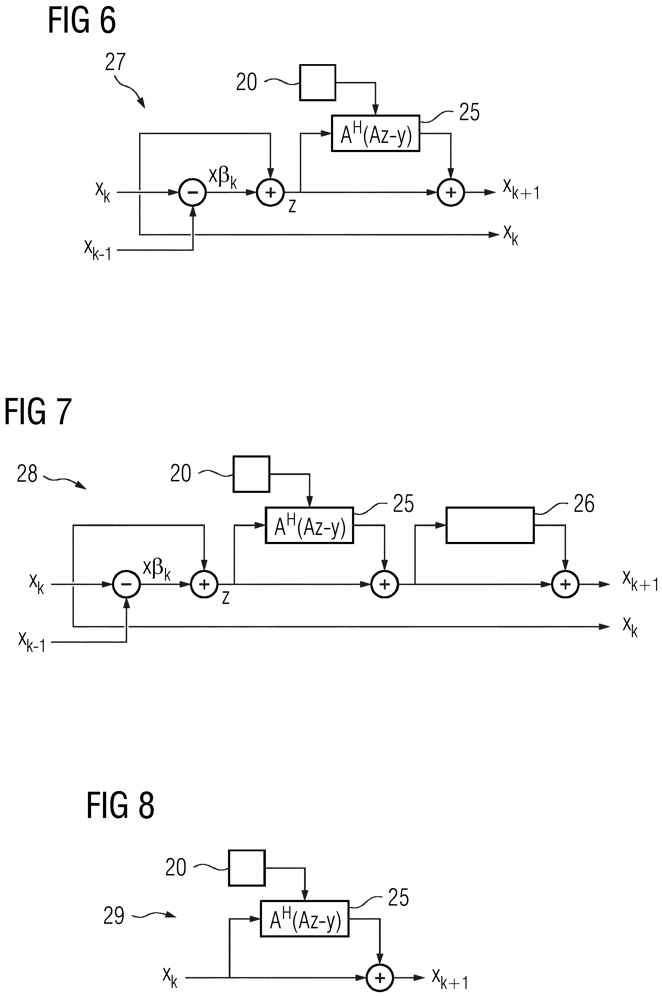

FIG 5 shows a schematic block diagram of a further exemplary embodiment of a computer-implemented method for image reconstruction according to the invention, which is based on the embodiment of FIG 4. In the embodiment of FIG 5, the processing steps 24 comprise the main cascades 28, one or more pre-cascades 27 and one or more post-cascades. An example for the pre-cascades 27 is shown schematically in FIG 6, an example for the main cascades 28 is shown schematically in FIG 7 and an example for the post-cascades 29 is shown schematically in FIG 8.

In the example of FIG 6, an iteration (k+1) of the pre-cascades 27 is shown. As an input, the output $x_k$ of the pre-cascades 27 for the previous iteration (k) and the output $x_{k-1}$ of the iteration (k-1) before that are provided and subtracted from each other. The difference is multiplied by a predefined factor $\beta_k$. The resulting product is added the $x_k$ to generate intermediate image data $z$. It is noted that the $\beta_k$ may be equal to zero in some embodiments. In this case $x_{k-1}$ is not required and $z = x_k$.

The data consistency operation is then carried out depending on the averaged MRI data y and the intermediate image data $z$ as $A^H(A z - y)$ with the forward operator $A$ and its adjoint $A^H$. The result is then added to $z$ to generate the output $x_{k+1}$.

In the example of FIG 7, an iteration (k+1) of the main cascades 28 is shown. As an input, the output $x_k$ of the main cascades 28 for the previous iteration (k) and the output $x_{k-1}$ of the iteration (k-1) before that are provided and subtracted from each other. The difference is multiplied by a predefined factor $\beta_k$. The resulting product is added to the $x_k$ to generate intermediate image data $z$. It is noted that the $\beta_k$ may be equal to zero in some embodiments. In this case $x_{k-1}$ is not required and $z = x_k$.

The data consistency operation is then carried out depending on the averaged MRI data y and the intermediate image data $z$ as $A^H(A z - y)$ with the forward operator $A$ and its adjoint $A^H$. The result is then fed as input into the trained MLM 26 and the output of the MLM 26 is added the input to the MLM 26 to generate the output $x_{k+1}$.

In the example of FIG 8, an iteration (k+1) of the post-cascades 29 is shown. As an input, the output $x_k$ of the post-cascades 29 for the previous iteration (k) is provided and corresponds to the intermediate image data $z$ in this case.

The data consistency operation is then carried out depending on the averaged MRI data y and the intermediate image data $z$ as $A^H(A z - y)$ with the forward operator $A$ and its adjoint $A^H$. The result is then added to $x_k$ to generate the output $x_{k+1}$.

It is noted that PAT averaging does practically not show aliasing artifacts associated with parallel imaging for the special case that the sampling number is equal to a multiple of the acceleration factor. This is related to the fact that for linear reconstructions, such as GRAPPA and SENSE, the reconstruction can be formulated in the image domain.

The reconstructed image $M(a)(x)$ for average $a$ can be calculated from the zero-padded, aliased coil images $D_I^{(a)}(x)$ with coil index I as

$$M^{(a)}(x) = \sum_I \omega_I^{(R)*}(x)\, D_I^{(a)}(x),$$

where the combination weights $\omega_I^{(R)}$ are sometimes also denoted as unmixing weights for GRAPPA and correspond to the pseudo-inverse of the encoding matrix for SENSE. Note that these combination weights are dependent on the acceleration factor R. In particular, $\omega_I^{(R)}$ can be assumed as spatially smooth. Since the average of multiple averages add up to a fully sampled acquisition, the averaged coil images

$$D_I(x) = \sum_a D_I^{(a)}(x)$$

do not show aliasing artifacts. Consequently, the averaged image

$$M(x) = \sum_a M^{(a)}(x) = \sum_{a,I} \omega_I^{(R)*}(x) \, D_I^{(a)}(x) = \sum_I \omega_I^{(R)*} \sum_a D_I^{(a)}(x)$$

is free of artifacts.

It is also pointed out that effective coil sensitivities can be derived that also mimic the averaging of independently reconstructed averages. For this purpose, consider

$$M(x) = \sum_I \omega_I^{(R)*}(x) \sum_a D_I^{(a)}(x)$$

and weighted averaging to fully sampled coil images

$$D_I(x) = \sum_a D_I^{(a)}(x)$$

For conventional fully sampled SENSE, the combination weights are just the coil sensitivity maps. Therefore, the averaging of sequentially acquired acquisitions with acceleration factor $R$ can be emulated by using $C_I(x) = \omega_I^{(R)}(x)$ as coil sensitivity maps.

For completeness it is recalled that SENSE in the image domain reconstructs the image as

$$M(x + \delta_r) = \sum_I \omega_I^{(R)*}(x + \delta_r) D_I(x),$$

where $\{\delta_r\}$ denotes the R offsets of aliased voxels. $\omega_I^{(R)*}(x + \delta_r)$ is the pseudo-inverse in indices I and r of the matrix $C$ $(x + \delta_r)$ for each position $x$.

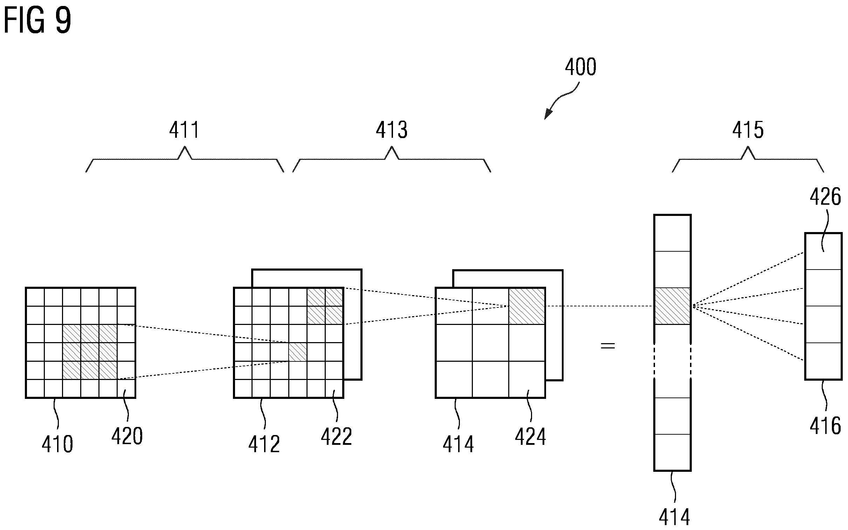

FIG 9 displays an exemplary embodiment of a convolutional neural network 400. In the displayed embodiment, the convolutional neural network 400 comprises an input node layer 410, a convolutional layer 411, a pooling layer 413, a fully connected layer 414 and an output node layer 416, as well as hidden node layers 412, 414. Alternatively, the convolutional neural network 400 can comprise several convolutional layers 411, several pooling layers 413 and/or several fully connected layers 415, as well as other types of layers. The order of the layers can be chosen arbitrarily, usually fully connected layers 415 are used as the last layers before the output layer 416.

In particular, within a convolutional neural network 400 nodes 420, 422, 424 of a node layer 410, 412, 414 can be considered to be arranged as a d-dimensional matrix or as a d-dimensional image. In particular, in the two-dimensional case the value of the node 420, 422, 424 indexed with i and j in the n-th node layer 410, 412, 414 can be denoted as x(n)[i, j]. However, the arrangement of the nodes 420, 422, 424 of one node layer 410, 412, 414 does not have an effect on the calculations executed within the convolutional neural network 400 as such, since these are given solely by the structure and the weights of the edges.

A convolutional layer 411 is a connection layer between an anterior node layer 410 with node values x(n-1) and a posterior node layer 412 with node values x(n). In particular, a convolutional layer 411 is characterized by the structure and the weights of the incoming edges forming a convolution operation based on a certain number of kernels. In particular, the structure and the weights of the edges of the convolutional layer 411 are chosen such that the values x(n) of the nodes 422 of the posterior node layer 412 are calculated as a convolution x(n) = K * x(n-1) based on the values x(n-1) of the nodes 420 anterior node layer 410, where the convolution * is defined in the two-dimensional case as

$$x^{(n)}[i, j] = \left( K * x^{(n-1)} \right)[i, j] = \sum_{i'} \sum_{j'} K[i', j'] \cdot x^{(n-1)}[i - i', j - j'].$$

Herein, the kernel K is a d-dimensional matrix, in the present example a two-dimensional matrix, which is usually small compared to the number of nodes 420, 422, for example a 3x3 matrix, or a 5x5 matrix. In particular, this implies that the weights of the edges in the convolution layer 411 are not independent, but chosen such that they produce said convolution equation. In particular, for a kernel being a 3x3 matrix, there are only nine independent weights, each entry of the kernel matrix corresponding to one independent weight, irrespectively of the number of nodes 420, 422 in the anterior node layer 410 and the posterior node layer 412.

In general, convolutional neural networks 400 use node layers 410, 412, 414 with a plurality of channels, in particular, due to the use of a plurality of kernels in convolutional layers 411. In those cases, the node layers can be considered as (d+1)-dimensional matrices, the first dimension indexing the channels. The action of a convolutional layer 411 is then in a two-dimensional example defined as

$$x_b^{(n)}[i,j] = \sum_a (K_{a,b} * x_a^{(n-1)}[i,j]) = \sum_a \sum_{i'} \sum_{j'} K_{a,b}[i',j'] \cdot x_a^{(n-1)}[i-i',j-j'],$$

wherein $x_a^{(n)}$ corresponds to the a-th channel of the anterior node layer 410, $x_b^{(n)}$ corresponds to the b-th channel of the posterior node layer 412 and $K_{a,b}$ corresponds to one of the kernels. If a convolutional layer 411 acts on an anterior node layer 410 with A channels and outputs a posterior node layer 412 with B channels, there are A·B independent d-dimensional kernels $K_{a,b}$.

In general, in convolutional neural networks 400 activation functions may be used. In this embodiment, ReLU (rectified linear unit) is used, with R(z) = max(0, z), so that the action of the convolutional layer 411 in the two-dimensional example is

$$x_b^{(n)}[i,j] = R\left(\sum_a (K_{a,b} * x_a^{(n-1)}[i,j])\right) = R\left(\sum_a \sum_{i'} \sum_{j'} K_{a,b}[i',j'] \cdot x_a^{(n-1)}[i-i',j-j']\right).$$

It is also possible to use other activation functions, for example ELU (exponential linear unit), LeakyReLU, Sigmoid, Tanh or Softmax.

In the displayed embodiment, the input layer 410 comprises 36 nodes 420, arranged as a two-dimensional 6x6 matrix. The first hidden node layer 412 comprises 72 nodes 422, arranged as two two-dimensional 6x6 matrices, each of the two matrices being the result of a convolution of the values of the input layer with a 3x3 kernel within the convolutional layer 411. Equivalently, the nodes 422 of the first hidden node layer 412 can be interpreted as arranged as a three-dimensional 2x6x6 matrix, wherein the first dimension corresponds to the channel dimension.

An advantage of using convolutional layers 411 is that spatially local correlation of the input data can exploited by enforcing a local connectivity pattern between nodes of adjacent layers, in particular by each node being connected to only a small region of the nodes of the preceding layer.

A pooling layer 413 is a connection layer between an anterior node layer 412 with node values x(n-1) and a posterior node layer 414 with node values x(n). In particular, a pooling layer 413 can be characterized by the structure and the weights of the edges and the activation function forming a pooling operation based on a non-linear pooling function f. For example, in the two-dimensional case the values x(n) of the nodes 424 of the posterior node layer 414 can be calculated based on the values x(n-1) of the nodes 422 of the anterior node layer 412 as

$$x_b^{(n)}[i,j] = f\left(x_b^{(n-1)}[id_1, jd_2], \dots, \quad x_b^{(n-1)}[(i+1)d_1 - 1, (j+1)d_2 - 1]\right).$$

In other words, by using a pooling layer 413, the number of nodes 422, 424 can be reduced by re-placing a number d1, d2 of neighboring nodes 422 in the anterior node layer 412 with a single node 422 in the posterior node layer 414 being calculated as a function of the values of said number of neighboring nodes. In particular, the pooling function f can be the max-function, the average, or the L2-Norm. In particular, for a pooling layer 413 the weights of the incoming edges are fixed and are not modified by training.

The advantage of using a pooling layer 413 is that the number of nodes 422, 424 and the number of parameters is reduced. This leads to the amount of computation in the network being reduced and to a control of overfitting.

In the displayed embodiment, the pooling layer 413 is a max-pooling layer, replacing four neighboring nodes with only one node, the value being the maximum of the values of the four neighboring nodes. The max-pooling is applied to each d-dimensional matrix of the previous layer. In this embodiment, the max-pooling is applied to each of the two two-dimensional matrices of the previous layer, reducing the number of nodes from 72 to 18.

In general, the last layers of a convolutional neural network 400 may be fully connected layers 415. A fully connected layer 415 is a connection layer between an anterior node layer 414 and a posterior node layer 416. A fully connected layer 413 can be characterized by the fact that a majority, in particular, all edges between nodes 414 of the anterior node layer 414 and the nodes 416 of the posterior node layer are present, and wherein the weight of each of these edges can be adjusted individually.

In this embodiment, the nodes 424 of the anterior node layer 414 of the fully connected layer 415 are displayed both as two-dimensional matrices, and additionally as non-related nodes, indicated as a line of nodes, wherein the number of nodes was reduced for a better presentability. This operation is also denoted as flattening. In this embodiment, the number of nodes 426 in the posterior node layer 416 of the fully connected layer 415 smaller than the number of nodes 424 in the anterior node layer 414. Alternatively, the number of nodes 426 can be equal or larger.

Furthermore, in this embodiment the Softmax activation function is used within the fully connected layer 415. By applying the Softmax function, the sum the values of all nodes 426 of the output layer 416 is 1, and all values of all nodes 426 of the output layer 416 are real numbers between 0 and 1. In particular, if using the convolutional neural network 400 for categorizing input data, the values of the output layer 416 can be interpreted as the probability of the input data falling into one of the different categories.

In particular, convolutional neural networks 400 can be trained based on the backpropagation algorithm. For preventing overfitting, methods of regularization can be used, for example dropout of nodes 420, ..., 424, stochastic pooling, use of artificial data, weight decay based on the L1 or the L2 norm, or max norm constraints.

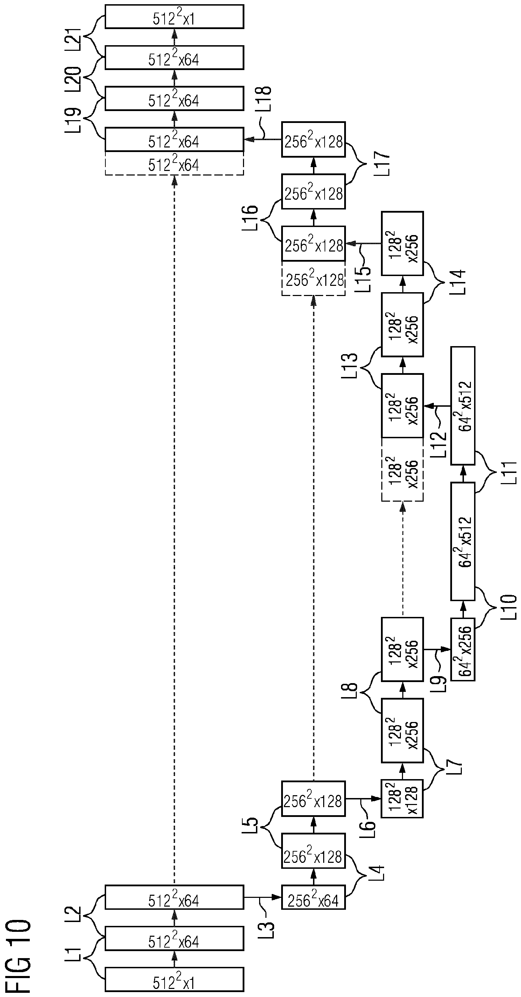

In the example of FIG 10, the MLM is a CNN, in particular, a convolutional neural network having a U-net structure. In the displayed example, the input data to the CNN is a two-dimensional medical image comprising 512x512 pixels, every pixel comprising one intensity value. The CNN comprises convolutional layers indicated by solid, horizontal arrows, pooling layers indicating by solid arrows pointing down, and upsampling layers indicated by solid arrows pointing up. The number of the respective nodes is indicated within the boxes. Within the U-net structure first the input images are downsampled, in particular by decreasing the size of the images and increasing the number of channels. Afterwards they are upsampled, in particular by increasing the size of the images and decreasing the number of channels, to generate a transformed image.

All except the last convolutional layers L1, L2, L4, L5, L7, L8, L10, L11, L13, L14, L16, L17, L19, L20 use 3x3 kernels with a padding of 1, the ReLU activation function, and a number of filters or convolutional kernels that matches the number of channels of the respective node layers as indicated in FIG 10. The last convolutional layer uses a 1x1 kernel with no padding and the ReLU activation function.

The pooling layers L3, L6, L9 are max-pooling layers, replacing four neighboring nodes with only one node, the value being the maximum of the values of the four neighboring nodes. The upsampling layers L12, L15, L18 are transposed convolution layers with 3x3 kernels and stride 2, which effectively quadruple the number of nodes. The dashed horizontal errors correspond to concatenation operations, where the output of a convolutional layer L2, L5, L8 of the downsampling branch of the U-net structure is used as additional inputs for a convolutional layer L13, L16, L19 of the upsampling branch of the U-net structure. This additional input data is treated as additional channels in the input node layer for the convolutional layer L13, L16, L19 of the upsampling branch.

Independent of the grammatical term usage, individuals with male, female or other gender identities are included within the term.

## Claims

1. Computer-implemented method for image reconstruction in magnetic resonance imaging, MRI, wherein

   - MRI data (20) is received, the MRI data (20) corresponding to an MRI acquisition according to a predefined sampling scheme, wherein the sampling scheme defines, for all k-space points (21), a corresponding sampling number indicating how often the respective k-space point has been sampled in the MRI acquisition;
   - reconstructed image data (X) is generated by applying processing steps (24) to predefined initial image data ($X_0$), the processing steps (24) comprising a data consistency operation (25) and a regularization operation (26);
   - a projection matrix according to the sampling scheme is received and the projection matrix is modified by scaling entries of the projection matrix depending on the respective sampling numbers defined by the sampling scheme; and
   - the data consistency operation (25) is carried out depending on a forward operator (A) comprising the modified projection matrix.

2. Computer-implemented method according to claim 1, wherein the MRI acquisition comprises two or more acquisition shots (22a, 22b, 22c, 22d, 22e), each of the two or more acquisition shots (22a, 22b, 22c, 22d, 22e) corresponding to an incomplete sampling of the k-space.

3. Computer-implemented method according to claim 2, wherein a subsampling scheme of a first acquisition shot (22a, 22b, 22c, 22d, 22e) of the two or more acquisition shots (22a, 22b, 22c, 22d, 22e) is identical or partially identical to a subsampling scheme of a second acquisition shot (22a, 22b, 22c, 22d, 22e) of the two or more acquisition shots (22a, 22b, 22c, 22d, 22e).

4. Computer-implemented method according to one of the preceding claims, wherein the scaling of a respective entry of the projection matrix comprises multiplying the respective entry with a factor $\alpha$, which is directly proportional to the corresponding sampling number.

5. Computer-implemented method according to claim 4 and one of claims 2 or3, wherein the factor $\alpha$ is indirectly proportional to an acceleration factor of the respective acquisition shot (22a, 22b, 22c, 22d, 22e).

6. Computer-implemented method according to one of the preceding claims, wherein the sampling number is at least two for a set of k-space points (23a) and the data consistency operation (25) comprises an averaging operation based on the MRI data (20) for the set of k-space points (23a).

7. Computer-implemented method according claim 6, wherein averaged MRI data (20) is computed by averaging respective values of the MRI data (20) corresponding to the same k-space point of the set of k-space points (23a) and the data consistency operation (25) is carried out depending on the averaged MRI data.

8. Computer-implemented method according to claim 7, wherein intermediate image data is determined depending on the initial image data $(X_0)$ and the data consistency operation (25) comprises

  - computing intermediate k-space data depending on the intermediate image data and the forward operator (A); and
  - computing a difference between the intermediate k-space data and the averaged MRI data (20).

9. Computer-implemented method according to claim 8, wherein the data consistency operation (25) comprises converting the difference into an image domain based on the forward operator (A) and computing a sum of the converted difference and the intermediate image data and the reconstructed image data (X) is generated depending on the sum.

10. Computer-implemented method according to claim 9, wherein regularized image data is generated by the regularization operation (26) depending on the sum and the reconstructed image data (X) is generated depending on the regularized image data.

11. Computer-implemented method according to one of the preceding claims, wherein the regularization operation (26) comprises a wavelet regularization or a total variation regularization.

12. Computer-implemented method according to one of claims 1 to 11, wherein the regularization operation (26) comprises an application of a trained machine learning model, MLM, for image enhancement and/or for image denoising and/or image sharpening and/or image resolution enhancement and/or image artifact reduction.

13. Data processing system (14), which is adapted to carry out a computer-implemented method according to one of the preceding claims.

14. MRI arrangement (1) comprising a data processing system (14) according to claim 13 and an MRI device (7), which is configured to generate the MRI data (20) by carrying out the MRI acquisition.

15. Computer program product comprising instructions, which, when executed by a data processing system (14), cause the data processing system (14) to carry out a computer-implemented method according to one of claims 1 to 12.

FIG 1

EP 4 741 864 A1

## FIG 2

## FIG 3

FIG 4

FIG 5

## FIG 6

## FIG 7

## FIG 8

FIG 9

FIG 10

EP 4 741 864 A1

Europäisches Patentamt
European Patent Office
Office européen des brevets

**EUROPEAN SEARCH REPORT**

Application Number

EP 24 21 2063

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BAO LIJUN ET AL: "Undersampled MR image reconstruction using an enhanced recursive residual network", JOURNAL OF MAGNETIC RESONANCE, ACADEMIC PRESS, ORLANDO, FL, US, vol. 305, 9 July 2019 (2019-07-09), pages 232-246, XP085735964, ISSN: 1090-7807, DOI: 10.1016/J.JMR.2019.07.020 [retrieved on 2019-07-09] | 1,2,4,5, 11-15 | INV. G01R33/56 ADD. G01R33/561 |
| A | * page 233 - page 238 * | 3,6-10 | |
| X | SHIJUN LIANG ET AL: "Adaptive Local Neighborhood-based Neural Networks for MR Image Reconstruction from Undersampled Data", ARXIV.ORG, CORNELL UNIVERSITY LIBRARY, 201 OLIN LIBRARY CORNELL UNIVERSITY ITHACA, NY 14853, 1 June 2022 (2022-06-01), XP091237754, | 1,2,4,5, 11-15 | |
| A | * page 2 - page 6 * | 3,6-10 | TECHNICAL FIELDS SEARCHED (IPC) |
| X | ELSAID NAHLA M H ET AL: "Constrained alternating minimization for parameter mapping (CAMP)", MAGNETIC RESONANCE IMAGING, ELSEVIER SCIENCE, TARRYTOWN, NY, US, vol. 110, 23 April 2024 (2024-04-23), pages 176-183, XP087532393, ISSN: 0730-725X, DOI: 10.1016/J.MRI.2024.04.029 [retrieved on 2024-04-23] | 1,2,4,5, 11,13-15 | G01R |
| A | * page 177 - page 180 * | 3,6-10 | |

The present search report has been drawn up for all claims

| Place of search | Date of completion of the search | Examiner |
|---|---|---|
| Munich | 31 March 2025 | Raguin, Guy |

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **G. ZENG et al.** A review on deep learning MRI reconstruction without fully sampled k-space.. *BMC Med Imaging*, 2021, vol. 21, 195
- **O. RONNEBERGER et al.** U-Net: Convolutional Networks for Biomedical Image Segmentation. *arXiv:1505.04597v1*
- **K. HAMMERNIK et al.** Σ-net: Systematic Evaluation of Iterative Deep Neural Networks for Fast Parallel MR Image Reconstruction. *arXiv:1912.09278v1*
- *Deep Resolve Boost, DRB*, 25 October 2024, https://www.siemens-healthineers.com/magnetic-resonance-imaging/options-and-upgrades/clinical-applications/deep-resolve-boost
- **J. HERMANN et al.** Feasibility and Implementation of a Deep Learning MR Reconstruction for TSE Sequences in Musculoskeletal Imaging. *Diagnostics*, 2021, vol. 11, 1484
- **S.H. JOSHI et al.** MRI resolution enhancement using total variation regularization. *Proc IEEE Int Symp Biomed Imaging*, 2009, 161-164
- **M. GUERQUIN-KERN et al.** Wavelet-regularized reconstruction for rapid MRI. *2009 IEEE International Symposium on Biomedical Imaging: From Nano to Macro, Boston, MA, USA*, 193-196
- **S. KANNENGIESSER et al.** Motion Compensation Using Parallel Imaging Without Extra Reference Measurements And With Modified Reordering. *Proc. Intl. Soc. Mag. Reson. Med.*, 2004, 11